# EUROPEAN PATENT APPLICATION

(11) **EP 4 813 731 A1**
(43) Date of publication of application: **30.09.2026**
(21) Application number: 25166706.9
(22) Date of filing: 27.03.2025
(51) Int. Cl.: B60L 53/302, H05K 7/20

(54) **HIGH-POWER DIRECT CURRENT CHARGING SYSTEM**

(71) Applicant: ABB E-mobility B.V., 2629 JG Delft (NL)
(72) Inventor: PICARD, Luc, 1930 Zaventem (BE)
(74) Representative: Zimmermann & Partner Patentanwälte mbB

(57) **Abstract**

A high-power direct current, HPDC, charging system for charging electric vehicles is provided. The HDPC charging system comprises a housing that defines a sealed compartment and a chimney compartment. It further comprises heat-generating electrical components located within the sealed compartment. The HDPC charging system is configured to deliver an output power of 20 kilowatts or more. The housing includes a thermally conductive portion providing thermal transfer between the sealed compartment and the chimney compartment. The housing further comprises a lower inlet opening and an upper outlet opening that enable an airflow between the chimney compartment and ambient air. The chimney compartment defines a substantially vertical airflow path from the lower inlet opening to the upper outlet opening passing along the thermally conductive portion. The sealed compartment is airtight relative to the chimney compartment and to ambient air.

## Description

### FIELD OF INVENTION

Embodiments of the present disclosure generally relate to the field of electric charging systems, and more specifically, to a high-power direct current, HPDC, charging system for charging electric vehicles.

### BACKGROUND OF INVENTION

High-power direct current, HPDC, charging systems have become increasingly important due to the growing prevalence of electric vehicles. To meet demands for convenience and efficiency, fast charging capabilities are essential, leading to ongoing efforts toward even shorter charging times. Standards such as the Megawatt Charging System, MCS, have emerged to enable significantly higher charging powers, reducing charging duration and making electric vehicle usage more practical and charging more comparable to conventional refueling.

However, faster charging inevitably generates substantial heat within charging infrastructure, creating thermal management challenges. Excessive heat, if not effectively managed, negatively impacts electrical components, potentially reducing their lifespan, safety, and reliability. Commonly used cooling methods rely on ambient air circulated actively, typically by fans drawing external air into the system, to dissipate heat efficiently.

Despite their simplicity, active cooling solutions that directly utilize ambient air introduce several drawbacks. Ambient air carries contaminants such as dust, pollen, moisture, and other particulate matter. Even advanced filtration cannot entirely prevent these contaminants from entering the charging system, potentially causing damage and accelerated deterioration of electronic components. Additionally, cooling components, like fans, directly exposed to ambient conditions are vulnerable to harsh weather, such as rain, snow, dust storms, and extreme temperatures. Depending on the circumstances, exposure to such conditions may increase the risk of reduced lifetime or efficiency or even of equipment failures, or at least of additional maintenance efforts to mitigate such risks.

Given these challenges, there is a need for cooling solutions that effectively manage heat generation in high-power electric vehicle charging systems while reducing at least some of the above-mentioned challenges. Thermal management strategies addressing these requirements may improve the reliability, durability, and safety of HPDC charging systems.

### SUMMARY OF INVENTION

It is therefore an object of the present invention to provide a HPDC charging system that at least partially addresses some of the above-mentioned problems.

Accordingly, a HPDC charging system for charging electric vehicles is provided. The HDPC charging system comprises a housing that defines a sealed compartment and a chimney compartment. It further comprises heat-generating electrical components located within the sealed compartment. The HDPC charging system is configured to deliver an output power of 20 kilowatts or more. The housing includes a thermally conductive portion providing thermal transfer between the sealed compartment and the chimney compartment. The housing further comprises a lower inlet opening and an upper outlet opening that enable an airflow between the chimney compartment and ambient air. The chimney compartment defines a substantially vertical airflow path from the lower inlet opening to the upper outlet opening passing along the thermally conductive portion. The sealed compartment is airtight relative to the chimney compartment and to ambient air.

Therefore, embodiments according to the claimed invention may ensure that electrical components remain effectively protected from contaminants and adverse environmental conditions. This can support reliable operation of the charging system in harsh outdoor environments, including exposure to dust, moisture, extreme temperatures, and other challenging conditions. Consequently, the invention facilitates outdoor installations, particularly where dependable performance and reduced maintenance requirements are desired.

In some embodiments, which may be combined with other embodiments described herein, the sealed compartment is sealed in accordance with appropriate sealing standards, such as an IP54, IP55, IP62, IP65 or IP66 ingress protection rating. This arrangement can facilitate reliable protection of internal components against dust, moisture, and other environmental contaminants, thus improving operational durability and reducing maintenance requirements.

In some embodiments, which may be combined with other embodiments described herein, the lower inlet opening is equipped with an air filter. The filter may be configured as a coarse particle filter, a mesh or screen filter for preventing entry of larger mechanical contaminants such as debris, sticks, stones, or leaves, a fine dust filter for smaller particulates, or a high-efficiency particulate air (HEPA) filter. This arrangement can facilitate reliable airflow by preventing accumulated debris or larger mechanical contaminants, such as leaves, twigs, or stones, from obstructing or significantly reducing an airflow through the airflow path. In alternative embodiments, which may be combined with other embodiments described herein, the lower inlet opening is not equipped with an air filter. This arrangement can facilitate reduced maintenance requirements and lower operational costs, as periodic inspection, cleaning, or replacement of filters becomes unnecessary. Additionally, by eliminating the filter, the complexity and manufacturing costs of the system may be reduced, without compromising the protection of electrical components which are protected within the sealed compartment.

In some embodiments, which may be combined with other embodiments described herein, the chimney compartment defines the airflow path as a passive airflow path. In particular, the airflow path may be configured to facilitate an airflow without support of active components, such as fans, relying instead on natural convection driven by temperature differences. Hence, a passive airflow may be established within the chimney compartment along the airflow path, in particular an airflow that is passively induced by natural convection. This arrangement can facilitate reliable heat dissipation without the need for active cooling devices, thereby reducing energy consumption, maintenance effort, system complexity, and susceptibility to mechanical failures.

In some embodiments, which may be combined with other embodiments described herein, the housing comprises a double-wall structure with an inner wall and an outer wall. The outer wall may be spaced apart from and parallel to the inner wall. The inner wall and the outer wall may bound the chimney compartment. The inner wall may comprise the thermally conductive portion.

In some embodiments, which may be combined with other embodiments described herein, the outer wall comprises the lower inlet opening and/or the upper outlet opening. In other embodiments, the upper outlet opening may be on a top side of the housing.

In some embodiments, which may be combined with other embodiments described herein, the thermally conductive portion extends substantially along a vertical dimension of the housing, preferably along at least 50%, more preferably along at least 75%, even more preferably along at least 90%, of the vertical dimension of the housing. This arrangement can support effective passive cooling, as heated air naturally rises vertically, establishing an airflow along the vertically extended thermally conductive portion.

In some embodiments, which may be combined with other embodiments described herein, the chimney compartment is configured for removing heat due to solar ingression onto the outer wall by increasing natural convection within the chimney compartment. This arrangement can limit temperatures in the sealed compartment despite solar ingression onto the outer wall, since the additional heat further enhances the natural convection and strengthens a respective chimney effect.

In some embodiments, which may be combined with other embodiments described herein, the thermally conductive portion has a thermal conductivity of at least 140 W/(m*K), or, preferably, of at least 180 W/(m*K), or, more preferably, of at least 200 W/(m*K). Alternatively or additionally, the thermally conductive portion may have an overall heat transfer coefficient of at least 7 W/(m²*K), or, preferably, of at least 8 W/(m²*K), or, more preferably, of at least 10 W/(m²*K). This arrangement can facilitate efficient heat dissipation from the sealed compartment to the chimney compartment.

In some embodiments, which may be combined with other embodiments described herein, the thermally conductive portion may comprise an aluminum alloy or consist of an aluminum alloy.

In some embodiments, which may be combined with other embodiments described herein, the thermally conductive portion may have a thickness between 2mm and 4mm, preferably between 2.5mm and 3.5mm, more preferably around 3mm.

In some embodiments, which may be combined with other embodiments described herein, the thermally conductive portion comprises a first side facing the sealed compartment and a second side facing the chimney compartment, wherein the infrared emissivity of the first side is smaller than that of the second side, preferably by a factor of 1.2, when measured over the 3-15 µm range and under temperatures between 0°C and 90°C.

In some embodiments, which may be combined with other embodiments described herein, the electrical components are arranged in a vertically intermediate region of the sealed compartment and the sealed compartment comprises a lower portion and an upper portion for permitting an air circulation loop passing through the upper and lower portions around the electrical components. The HPDC charging system may comprise at least one fan or blower positioned in the sealed compartment. The fan or blower may be configured for blowing air along the air circulation loop. This arrangement can facilitate guidance of air within the sealed compartment along the thermally conductive portion, thereby increasing heat transfer efficiency while avoiding the risk of damage or contamination of the fan or blower, since the circulated air remains substantially free of external contaminants.

In some embodiments, which may be combined with other embodiments described herein, the electrical components comprise high-heat electrical components and low-heat electrical components, wherein the high-heat electrical components have a higher temperature rating than the low-heat electrical components. In particular, the high-heat electrical components can withstand or operate reliably at higher temperatures compared to the low-heat electrical components. The electrical components may be vertically arranged such that the low-heat electrical components are positioned below the high-heat electrical components. This arrangement can facilitate improved thermal management, as the low-heat electrical components, which require lower operating temperatures, may remain relatively cool due to their lower vertical position.

In some embodiments, which may be combined with other embodiments described herein, the low-heat electrical components may comprise one or more of an electrolytic capacitor, a semiconductor such as an Insulated Gate Bipolar Transistor, IGBT, a Metal-Oxide-Semiconductor Field-Effect Transistor, MOSFET, a diode, a printed circuit board, PCB, or a microcontroller. The high-heat electrical components may comprise one or more of a fuse, a busbar, a conductor, or a power resistor.

In some embodiments, which may be combined with other embodiments described herein, the thermally conductive portion comprises fins extending into the sealed compartment and/or into the chimney compartment configured to increase the surface area of the thermally conductive portion. This arrangement can facilitate increased heat transfer from the sealed compartment to the chimney compartment, as the increased surface area provided by the fins enables a higher rate of heat dissipation

In some embodiments, which may be combined with other embodiments described herein, the HPDC charging system further comprises an adaptive airflow management system configured to dynamically regulate airflow within the sealed compartment, preferably by means of one or more variable-speed fans, in response to changing thermal conditions within the sealed compartment or the ambient air. This arrangement can facilitate maintaining stable operating temperatures within the sealed compartment despite variations in internal or external conditions.

In some embodiments, which may be combined with other embodiments described herein, the HPDC charging system further comprises a connector for delivering power to a vehicle, the connector being an MCS connector. In some embodiments, the MCS connector is configured for charging with a maximum charging rate of at least 1300 Ampere, preferably at least 1500 Ampere, more preferably at least 2000 Ampere. In these cases, effective cooling can be particularly advantageous, as high charging currents typically generate substantial heat that must be efficiently dissipated to ensure reliable operation.

In some embodiments, which may be combined with other embodiments described herein, a total internal volume defined by the chimney compartment is smaller than a total internal volume defined by the sealed compartment, preferably by a factor of 1.5 or more, or 2.5 or more, or 3.5 or more. In some embodiments, the sealed compartment and the chimney compartment may be configured such that each compartment is substantially cuboid-shaped. The sealed compartment and the chimney compartment may share the inner wall as a common dividing wall. Consequently, the chimney compartment and the sealed compartment may have substantially identical height and depth dimensions but may differ in their respective widths. For instance, the width of the sealed compartment may be 1.5 or more, 2.5 or more, or 3.5 or more times the width of the chimney compartment. Such arrangements with a relatively smaller chimney compartment can facilitate increased airflow velocity, resulting in more effective convective heat transfer.

In some embodiments, which may be combined with other embodiments described herein, the HPDC charging system is configured for charging electric trucks, buses, or other commercial vehicles with high power demands. For charging systems configured for charging such electric vehicles, effective thermal management is particularly advantageous, as such systems typically operate at particularly high charging currents, thereby generating substantial heat that must be efficiently dissipated.

In some embodiments, which may be combined with other embodiments described herein, the HPDC charging system is configured as an MCS. Such an MCS configuration is particularly advantageous for electric vehicles with high power requirements, such as trucks, buses, or other commercial vehicles. The MCS enables rapid charging, thereby reducing vehicle downtime.

Further aspects, advantages and features of the present disclosure are apparent from the description and the accompanying drawings.

### BRIEF DESCRIPTION OF DRAWINGS

Embodiments of the present disclosure will be presented in the sense of examples in detail below, with reference to the accompanying drawings, wherein:
- FIG. 1: shows a schematic cross-sectional view of an HDPC charging system for electric vehicles according to embodiments described herein; and
- FIG. 2: shows a schematic cross-sectional view of an HDPC charging system for electric vehicles according to embodiments described herein.

### DETAILED DESCRIPTION OF EMBODIMENTS

Hereinafter, aspects of the present disclosure will be described with reference to the illustrative embodiments. It should be understood that all these embodiments are given merely for the skilled in the art to better understand and further practice the present disclosure, but not for limiting the scope of the present disclosure. For example, features illustrated or described as part of one embodiment may be used with another embodiment to yield still a further embodiment. In the interest of clarity, not all features of an actual implementation are described in this specification. It will be appreciated that in the development of any such actual embodiment, numerous implementation-specific decisions should be made to achieve the developers' specific goals, such as compliance with system-related and business-related constraints, which will vary from one implementation to another. Moreover, it will be appreciated that such a development effort might be complex and time-consuming, but would nevertheless be a routine undertaking for those of ordinary skill in the art having the benefit of this disclosure.

The disclosed subject matter will now be described with reference to the attached figures. Various structures, systems and devices are schematically depicted in the drawings for purposes of explanation only and so as to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art.

Within the following description of the drawings, same reference numbers refer to same components or components having substantially the same function. Each example is provided by way of explanation and is not meant as a limitation of the present disclosure. Features illustrated or described as part of one embodiment can be used on or in conjunction with other embodiments to yield yet a further embodiment. It is intended that the description includes such modifications and variations.

In the following, different variants for the solution described in the present application are disclosed.

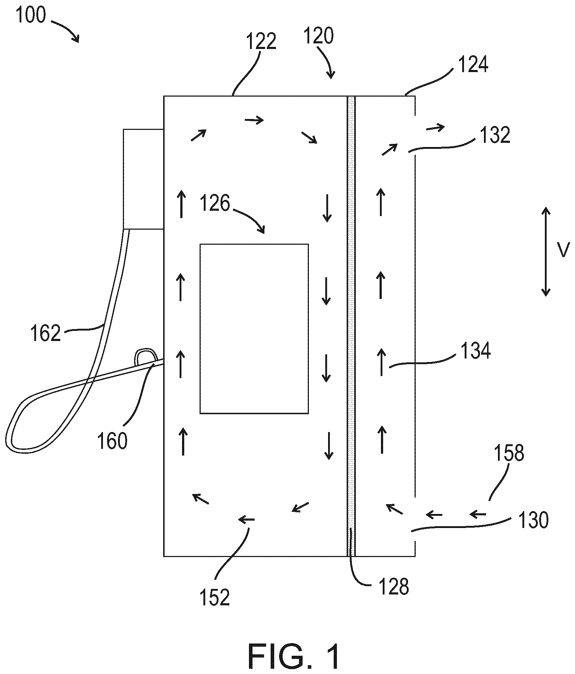

The following paragraphs refer to the embodiment shown in FIG. 1.

FIG. 1 shows a cross-sectional schematic view of an HDPC charging system 100 for electric vehicles, for instance electric vehicles requiring high-power and/or rapid charging, such as heavy-duty vehicles, trucks, buses, or other commercial vehicles.

The charging system 100 comprises a housing 120, which defines a sealed compartment 122 and a chimney compartment 124. The housing 120 is typically constructed from robust, weather-resistant materials to withstand outdoor conditions.

The housing 120 comprises a thermally conductive portion 128 providing thermal transfer between the sealed compartment 122 and the chimney compartment 124. The thermally conductive portion 128 of the housing 120 may be made of a suitable thermally conductive material such as aluminum, copper, or alloys thereof, or may consist of composite materials or thermally conductive polymers.

The sealed compartment 122 is airtight relative to the chimney compartment 124 and to ambient air 158. The sealed compartment 122 houses heat-generating electrical components 126. Since the sealed compartment 122 is airtight relative to ambient air 158, the electrical components 126 housed therein can be protected against moisture, dust, and other contaminants. Hence, the sealed configuration advantageously enables reliable operation of the charging system 100 under demanding environmental conditions. This allows the charging system 100 to be deployed outdoors and in harsh environments, such as industrial areas, roadside installations, or locations with elevated pollution levels.

The housing 120 comprises a lower inlet opening 130 and an upper outlet opening 132 that enable an airflow between the chimney compartment 124 and ambient air 158. The chimney compartment 124 defines a substantially vertical airflow path 134 from the lower inlet opening 130 to the upper outlet opening 132 passing along the thermally conductive portion 128. The vertical orientation is indicated by the vertical arrow V.

Ambient air 158 may enter through the lower inlet opening 130. During operation of the electrical charging system 100, the electrical components 126 may generate heat, which is dissipated into the chimney compartment 124 via the thermally conductive portion 128. Accordingly, the entered ambient air 158 is heated, rises and ultimately leaves the charging system 100 via the upper outlet opening 132, thereby allowing heat transferred to the chimney compartment 124 to be dissipated via natural convection. This passive cooling arrangement is advantageous as it reduces system complexity and potential points of failure, enhancing reliability and simplifying maintenance. Additionally, it lowers operational noise, which is beneficial in noise-sensitive environments.

The charging system 100 further comprises a charging plug 160 and a charging cable 162 configured for connecting the charging system 100 to an electric vehicle.

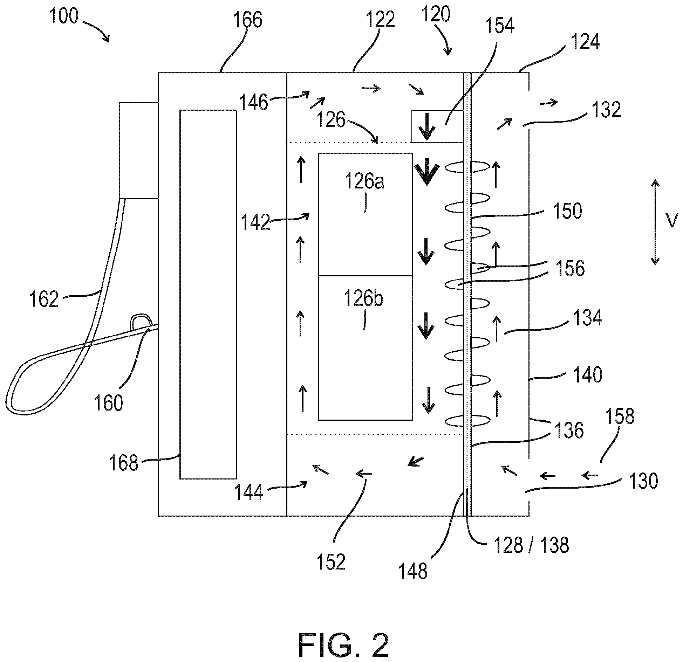

The following paragraphs refer to the embodiment shown in FIG. 2.

FIG. 2 illustrates a cross-sectional schematic view of an HDPC charging system 100 according the invention. Components that are identical or have substantially the same technical purpose as in FIG. 1 are denoted by the same reference numerals.

The charging system 100 comprises a housing 120, which defines a sealed compartment 122 and a chimney compartment 124. The sealed compartment 122 is airtight relative to the chimney compartment 124 and to ambient air 158. The housing 120 may comprise a double-wall structure 136 bounding the chimney compartment with an inner wall 138 and an outer wall 140. The outer wall 140 may be spaced apart and parallel to the inner wall 138. The chimney compartment 124 may be bounded on opposite sides by the inner wall 138 and the outer wall 140. The inner wall 138 may also bound a side of the sealed compartment 122.

The inner wall 138 may comprise a thermally conductive portion 128 providing thermal transfer between the sealed compartment 122 and the chimney compartment 124. The thermally conductive portion 128 may extend substantially along a vertical dimension of the housing 120. In the embodiment shown in FIG. 2, the thermally conductive portion 128 extends along the entire vertical dimension of the housing 120. The vertical orientation is indicated by the vertical arrow V.

The outer wall 140 may comprise a lower inlet opening 130 and an upper outlet opening 132 that enable an airflow between the chimney compartment 124 and ambient air 158. The chimney compartment 124 defines a substantially vertical airflow path 134 from the lower inlet opening 130 to the upper outlet opening 132 passing along the thermally conductive portion 128.

Ambient air 158 may enter through the lower inlet opening 130. During operation of the electrical charging system 100, the electrical components 126 generate heat, which, at least partially, is dissipated into the chimney compartment 124 via the thermally conductive portion 128. Accordingly, the entered ambient air 158 may be heated, may rise and ultimately leave the charging system 100 via the upper outlet opening 132, thereby allowing heat transferred to the chimney compartment 124 to be dissipated via natural convection.

The arrangement may permit an air circulation loop 152 around the electrical components 126 within the sealed compartment 122. The arrangement may be configured such that an airflow may flow along the air circulation loop 152. This may be due to passive means, like natural convection, or due to active means, for instance blower or fans. In Fig. 1 the airflow along the air circulation loop 152 indicated by the arrows in the sealed compartment 122 is oriented such that it passes along the thermally conductive portion 128 essentially from top to bottom. In different embodiments, the arrangement may be configured such that the direction of the airflow is reversed.

The thermally conductive portion 128 may have a thermal conductivity of at least 140 W/(m*K) or, preferably, of at least 200 W/(m*K). Alternatively or additionally, the thermally conductive portion 128 may have an overall heat transfer coefficient of at least 7 W/(m2*K), or, preferably, of at least 10 W/(m2*K).

The thermally conductive portion 128 may comprise a first side 148 facing the sealed compartment 122 and a second side 150 facing the chimney compartment 124. The infrared emissivity of the first side 148 may be smaller than that of the second side 150, preferably by a factor of 1.2, when measured over the 3-15 µm range and under temperatures between 0°C and 90°C.

The thermally conductive portion 128 may comprise fins 156 extending into the sealed compartment 122 and into the chimney compartment 124 configured to increase the surface area of the thermally conductive portion 128. In different embodiments, the thermally conductive portion 128 may comprise fins that extend only into either the sealed compartment 122 or the chimney compartment 124. In different embodiments, the thermally conductive portion 128 may not comprise fins.

The sealed compartment may be sealed in accordance with appropriate sealing standards, such as an IP54, IP55, IP62, IP65 or IP66 ingress protection rating.

The sealed compartment 122 houses heat-generating electrical components 126. These electrical components 126 may be arranged in a vertically intermediate region 142 of the sealed compartment 122. The sealed compartment may have a lower portion 144 below the vertically intermediate region 142 and an upper portion 146 above the vertically intermediate region 142. The horizontal dotted lines illustrate the arrangement of the lower portion 144, the vertically intermediate region 142, and the upper portion 146 within the sealed compartment 122. This arrangement may permit an air circulation loop 152 passing through the upper and lower portions 146 and 144 around the electrical components 126.

A fan or blower 154 may be positioned in the sealed compartment. The fan or blower 154 may be configured for blowing air along the air circulation loop 152. A respective airflow is indicated by the arrows within the sealed compartment 122. The orientation of the airflow may be defined through the direction, position and configuration of the fan or blower 154. In Fig. 2 the airflow along the airflow circulation loop 152 indicated by the arrows in the sealed compartment 122 is oriented such that it passes along the thermally conductive portion 128 essentially from top to bottom. In different embodiments, the fan or blower 154 may be configured such that the direction of the airflow is reversed.

The fan or blower 154 may be a variable-speed fan that is configured as part of an adaptive airflow management system configured to dynamically regulate an airflow within the sealed compartment 122 in response to changing thermal conditions within the sealed compartment 122 or the ambient air 158.

The electrical components 126 comprise high-heat electrical components 126a and low-heat electrical components 126b, wherein the high-heat electrical components 126a have a higher temperature rating than the low-heat electrical components 126b. The low-heat electrical components 126b are positioned below the high-heat electrical components 126a within the sealed compartment.

The low-heat electrical components 126b may comprise at least one of an electrolytic capacitor, a semiconductor such as an IGBT, a MOSFET, a diode, a PCB, or a microcontroller. Alternatively or additionally, the high-heat electrical components 126a may comprise at least one of a fuse, a busbar, a conductor, or a power resistor.

The internal volume of the chimney compartment 124 may be less than half the internal volume of the sealed compartment 122. The sealed compartment 122 and the chimney compartment 124 may both be substantially cuboid-shaped and bounded by the inner wall 138, which may respectively define one side surface of each compartment. Consequently, the chimney compartment 124 and the sealed compartment 122 may have substantially identical height and depth dimensions, but may differ in their respective widths.

The charging system 100 may further comprise a charging plug 160 and a charging cable 162 configured for connecting the charging system 100 to an electric vehicle.

The charging system may further comprise a fully ventilated compartment 166 separate from the sealed compartment 122 and separate from the chimney compartment 124. The fully ventilated compartment may comprise one or more ventilation openings 168. The fully ventilated compartment 166 may be actively cooled, for instance by fans or blowers configured to direct ambient air through the fully ventilated compartment 166. The fully ventilated compartment 166 may comprise a cable cooling system.

This written description, together with the accompanying drawings, describes exemplary embodiments of the invention by way of example only. It enables any person skilled in the art to practice the described subject-matter, including making and using any devices or systems. While various specific embodiments have been disclosed in the foregoing, mutually non-exclusive features of the embodiments described above may be combined with each other. The patentable scope is defined by the claims, and other examples are intended to be within the scope of the claims if they have structural elements that do not differ from the literal language of the claims, or if they include equivalent structural elements with insubstantial differences from the literal language of the claims.

### REFERENCE SIGNS

- 100: HPDC charging system
- 120: housing
- 122: sealed compartment
- 124: chimney compartment
- 126: electrical components
- 126a: high-heat electrical components
- 126b: low-heat electrical components
- 128: thermally conductive portion
- 130: lower inlet opening
- 132: upper outlet opening
- 134: airflow path
- 136: double wall structure
- 138: inner wall
- 140: outer wall
- 142: vertically intermediate region
- 144: lower portion of sealed compartment
- 146: upper portion of sealed compartment
- 148: first side of thermally conductive portion
- 150: second side of thermally conductive portion
- 152: air circulation loop
- 154: fan or blower
- 156: fins
- 158: ambient air
- 160: charging plug
- 162: charging cable
- 166: fully ventilated compartment
- 168: ventilation opening
- V: vertical orientation

## Claims

1. A high-power direct current, HPDC, charging system (100) for charging electric vehicles comprising a housing (120) that defines a sealed compartment (122) and a chimney compartment (124), and comprising heat-generating electrical components (126) located within the sealed compartment (122), wherein:
the HDPC charging system (100) is configured to deliver an output power of 20 kilowatts or more;
the housing (120) includes a thermally conductive portion (128) providing thermal transfer between the sealed compartment (122) and the chimney compartment (124);
the housing (120) comprises a lower inlet opening (130) and an upper outlet opening (132) that enable an airflow between the chimney compartment (124) and ambient air (158), the chimney compartment (124) defining a substantially vertical airflow path (134) from the lower inlet opening (130) to the upper outlet opening (132) passing along the thermally conductive portion (128); and
the sealed compartment (124) is airtight relative to the chimney compartment (124) and to ambient air (158).

2. The HPDC charging system (100) of claim 1, wherein the chimney compartment (124) defines the airflow path (134) as a passive airflow path (134).

3. The HPDC charging system (100) of claim 1 or 2, wherein the housing (120) comprises a double-wall structure (136) with an inner wall (138) and an outer wall (140), wherein the outer wall (140) is spaced apart from and parallel to the inner wall (138), wherein the inner wall (138) and the outer wall (140) bound the chimney compartment (124), and wherein the inner wall (138) comprises the thermally conductive portion (128).

4. The HPDC charging system of claim 3, wherein the outer wall (140) comprises the lower inlet opening (130) and/or the upper outlet opening (132).

5. The HPDC charging system (100) of any one of claims 1 - 4, wherein the thermally conductive portion (128) extends substantially along a vertical dimension of the housing, preferably along at least 75% of the vertical dimension.

6. The HPDC charging system of any one of claims 3 - 5, wherein the chimney compartment (124) is configured for removing heat due to solar ingression onto the outer wall (140) by increasing natural convection within the chimney compartment (124).

7. The HPDC charging system (100) of any one of claims 1 - 6, wherein the thermally conductive portion (128) has a thermal conductivity of at least 180W/(m*K) and/or an overall heat transfer coefficient of at least 8 W/(m^{2*}K).

8. The HPDC charging system (100) of any one of claims 1 - 7, wherein the thermally conductive portion (128) comprises a first side (148) facing the sealed compartment (122) and a second side (150) facing the chimney compartment (124), wherein the infrared emissivity of the first side (148) is smaller than that of the second side (150), preferably by a factor of 1.2, when measured over the 3-15 µm range and under temperatures between 0°C and 90°C.

9. The HPDC charging system (100) of any one of claims 1 - 8, wherein the electrical components (126) are arranged in a vertically intermediate region (142) of the sealed compartment (122), the sealed compartment comprising a lower portion (144) and an upper portion (146) for permitting an air circulation loop (152) passing through the upper and lower portions (146, 144) around the electrical components (126), wherein the HPDC charging system (100) comprises at least one fan or blower (154) positioned in the sealed compartment (122), wherein the fan or blower (154) is configured for blowing air along the air circulation loop (152).

10. The HPDC charging system (100) of any one of claims 1 - 9, wherein the electrical components (126) comprise high-heat electrical components (126a) and low-heat electrical components (126b), wherein the high-heat electrical components (126a) have a higher temperature rating than the low-heat electrical components (126b), and wherein the electrical components (126) are vertically arranged such that the low-heat electrical components (126b) are positioned below the high-heat electrical components (126a).

11. The HPDC charging system (100) of claim 10, wherein the low-heat electrical components (126b) comprise at least one of an electrolytic capacitor, a semiconductor such as an Insulated Gate Bipolar Transistor, IGBT, a Metal-Oxide-Semiconductor Field-Effect Transistor, MOSFET, or a diode, a printed circuit board, PCB, or a microcontroller, and wherein the high-heat electrical components (126a) comprise at least one of a fuse, a busbar, a conductor, or a power resistor.

12. The HPDC charging system (100) of any one of claims 1 - 11, wherein the thermally conductive portion (128) comprises fins (156) extending into the sealed compartment (122) and/or into the chimney compartment (124) configured to increase the surface area of the thermally conductive portion (128).

13. The HPDC charging system (100) of any one of claims 1 - 12, further comprising an adaptive airflow management system configured to dynamically regulate airflow within the sealed compartment (122), preferably by means of one or more variable-speed fans, in response to changing thermal conditions within the sealed compartment (122) or the ambient air (158).

14. The HPDC charging system (100) of any one of claims 1 - 13, wherein the HPDC charging system (100) comprises a connector for delivering power to a vehicle, the connector being a Megawatt Charging System, MCS, connector.

15. The HPDC charging system (100) of any one of claims 1 - 14, wherein a total internal volume defined by the chimney compartment is smaller than a total internal volume defined by the sealed compartment, preferably by a factor of 2.5 or more.
